(19) Europäisches Patentamt

European Patent Office

Office européen des brevets

(11) **EP 1 508 925 A2**

(12) **EUROPEAN PATENT APPLICATION**

(43) Date of publication:
**23.02.2005 Bulletin 2005/08**

(51) Int Cl.⁷: **H01L 51/20**, H01L 51/30

(21) Application number: **04019700.6**

(22) Date of filing: **19.08.2004**

| | |
|---|---|
| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK**<br><br>(30) Priority: **22.08.2003 JP 2003298716**<br>　　　　　　**29.01.2004 JP 2004021975**<br><br>(71) Applicants:<br>　• **National University Corporation Kanazawa University**<br>　　**Kanazawa-shi, Ishikawa 920-1164 (JP)**<br>　• **Nippon Shokubai Co., Ltd.**<br>　　**Osaka-shi, Osaka 541-0043 (JP)** | (72) Inventors:<br>　• **Takahashi, Kohshin**<br>　　**Ishikawa-gun Ishikawa 920-2165 (JP)**<br>　• **Nakamura, Junichi**<br>　　**Takatsuki-shi Osaka 569-0854 (JP)**<br>　• **Yokoe, Chiho**<br>　　**Kakogawa-shi Hyogo 675-0014 (JP)**<br>　• **Murata, Kazuhiko**<br>　　**Suita-shi Osaka 564-0062 (JP)**<br><br>(74) Representative: **Glawe. Delfs. Moll**<br>　　**Patentanwälte**<br>　　**Postfach 26 01 62**<br>　　**80058 München (DE)** |

(54) **Organic solar cell and its production process**

(57)　An object of the present invention is to enhance the photoelectric conversion performance to more than the limit possessed by prior organic solar cells in arts of organic solar cells in which an organic semiconductor layer is constituted by at least two material layers. As a means of achieving this object, the organic solar cell according to the present invention is an organic solar cell comprising a pair of electrode layers 10, 30 and therebetween an organic semiconductor layer 20 including at least two material layers, wherein the organic semiconductor layer 20 includes: a first material layer 24 having thickness-wise through spaces; a second material layer 22 (formed from such as a soluble material) being disposed adjacently to the first material layer 24; and a mingled range 26 which is disposed in a part, adjacent to the second material layer 22, of the first material layer 24 and formed by such as a process including the steps of making a liquid film of a soluble material (this material is to form the second material layer 22) penetrate and then hardening it and in which a part of the material of the second material layer 22 is mingled with the first material layer 24 in the form of having entered the through spaces of the first material layer 24.

Fig. 1

EP 1 508 925 A2

**Description**

**BACKGROUND OF THE INVENTION**

A. TECHNICAL FIELD

The present invention relates to an organic solar cell and its production process. Specifically, the present invention relates to: an organic solar cell which utilizes a photoelectric conversion action possessed by an organic semiconductor; and a process for production of such an organic solar cell.

B. BACKGROUND ART

Unlike a solar cell which utilizes an inorganic semiconductor (e.g. silicon), an organic solar cell utilizes an organic semiconductor made from an organic material (e.g. synthetic polymer).

The organic semiconductor has merits such as of being lower in price of its material and easier to produce than the inorganic semiconductor. However, at the current stage, the organic semiconductor is lower in photoelectric conversion efficiency than the inorganic semiconductor, so an organic semiconductor which is high in photoelectric conversion efficiency is under development in order to make it practicable.

Non-patent document 1 below discloses an art in which perylenebenzimidazole (PBI) and poly[2,5-dimethoxy-1,4-phenylene-1,2-ethanylene-2-methoxy-5-(2-ethylhexyloxy)-1,4-phenylene-1,2-ethanylene] (M3EH-PPV) are joined together as organic semiconductors. This document reports that a photoelectric conversion efficiency $\eta$ =0.71 % (80 mW/cm$^2$) can be achieved by an organic solar cell having a layer constitution of ITO/PBI/M3EH-PPV/Au.

A process for production of this organic solar cell includes the steps of: forming the PBI layer on an ITO-filmed glass substrate by vapor deposition; and then coating further thereon a polymer solution (which is to form the M3EH-PPV layer) by a spin-casting method; and then heat-hardening it. In the heat-hardening step, the residual solvent is removed by making the environment a vacuum.

[Non-Patent Document 1] "Polymer — Perylene Diimide Heterojunction Solar Cells: A. J. Breeze et al." (APPLIED PHYSICS LETTERS, 14 OCTOBER 2002, American Institute of Physics, USA), pp. 3085-3087

Even the organic solar cell of the aforementioned prior art is insufficient in photoelectric conversion efficiency and it is therefore difficult to say that this organic solar cell is a solar cell high in utility or in commercial value.

In the art of the non-patent document 1 above, an organic semiconductor layer is constituted by joining two kinds of semiconductor layers (namely, the PBI layer and the M3EH-PPV layer) together. However, it can be considered that, because the photoelectric conversion action occurring between materials of both layers results in occurring substantially only in a boundary face between both layers, the range where the photoelectric conversion action occurs is so small that no sufficient photoelectric conversion efficiency can be achieved. In both layers, materials of portions located apart from the boundary face do not participate in the photoelectric conversion action so much.

An art is also known in which, as the organic semiconductor layer, a mixed layer is formed by mixing at least two materials together. However, even if the mixed layer is formed, the photoelectric conversion efficiency is not enhanced so much and, as the case may be, the photoelectric conversion efficiency becomes lower than that in the case of the two-layer structure. As its reason, there is a problem that, in the case of the mixed layer, both of the two kinds of materials (which participate in the photoelectric conversion action) are disposed adjacently to electrode layers which are disposed on both sides of the organic semiconductor layer. It can be considered that the electric potential barriers between the electrode layers and one of the semiconductor materials are unfavorably low, so that the photoelectric conversion action does not successfully work.

**SUMMARY OF THE INVENTION**

A. OBJECT OF THE INVENTION

An object of the present invention is to achieve the enhancement of the photoelectric conversion efficiency to more than the limit possessed by prior organic solar cells in the aforementioned arts of organic solar cells in which the organic semiconductor layer is constituted by two kinds of materials.

B. DISCLOSURE OF THE INVENTION

An organic solar cell according to the present invention is an organic solar cell comprising a pair of electrode layers and therebetween an organic semiconductor layer including at least two material layers, wherein the organic semiconductor layer includes: a first material layer having thickness-wise through spaces; a second material layer being disposed adjacently to the first material layer; and a mingled range which is disposed in a part, adjacent to the second material layer, of the first material layer and in which a part of a material of the second material layer is mingled with the first material layer in the form of having entered the through spaces of the first material layer.

[Organic solar cell]:

Basically, as long as being an organic solar cell which generates electricity by the photoelectric conversion action of the organic semiconductor, then the organic solar cell can be constituted by combining arts common to conventional organic solar cells.

The basic constitution of the organic solar cell comprises the pair of electrode layers and the organic semiconductor layer disposed therebetween. The pair of electrode layers usually have: a transparent electrode layer disposed at the light-incident side; and a collector electrode layer disposed at its opposite side. The energy of light (e.g. sunlight) irradiated to the organic semiconductor layer from the transparent electrode layer side is converted into electric energy by the organic semiconductor layer (which is a photoelectric conversion cell) to thus generate the electromotive force between the transparent electrode layer and the collector electrode layer.

Combinations of energy levels of the electrode layers and the organic semiconductor layer make differences in photoelectric conversion performance. Accordingly, the photoelectric conversion efficiency of the organic solar cell depends basically on the selection of the material of the organic semiconductor layer. However, relations of the organic semiconductor layer with both electrode layers are also important.

[Electrode layers]:

To the electrode layers, there are applied materials, structures, and production processes common to conventional organic solar cells.

As the pair of electrode layers, usually, the transparent electrode layer and the collector electrode layer are combined together.

Usable as the transparent electrode layer is a transparent electrode layer produced by forming a transparent electrode layer from a transparent electrically conductive material on a surface of a transparent glass or plastic film. Favorably, the material of the transparent electrode layer has sufficient light transmissibility and electric conductivity.

Examples of the material of the transparent electrode include: electrically conductive metal oxides (e.g. ITO (indium-tin oxide), FTO (F-doped tin oxide)); thin films of carbon; and electrically conductive polymers. The material may be a material obtained by forming a conventional electrically conductive metal film into a thin layer to thus enhance the light transmissibility. A favorable material is the ITO which is easy to industrially utilize and well balanced also in performance. It is also possible to constitute the transparent electrode layer by laying at least two material layers on each other. The thickness of the transparent electrode layer can be set in the range of 1 to 10,000 nm, favorably 10 to 300 nm. The light transmissibility of the transparent electrode layer is usually set at a light transmittance of not less than 70 %, favorably in the range of 75 to 100 %. The light transmittance is specified as that in the wavelength range of 450 to 900 nm. Particularly favorable is a material of which the light transmittance is high in the range near 500 nm which range is the visible light range in the wavelength range of the sunlight.

If being excellent in the electric conductivity, then the collector electrode layer does not need to have light transmissibility like the transparent electrode layer. There can be adopted the same materials and structures as of collector electrode layers utilized for conventional organic solar cells. Usable as materials of the collector electrode layer are metallic, inorganic, and organic materials which have electric conductivity. Specific examples thereof include Au, Ag, Al, and Ca. The thickness of the collector electrode layer can be set usually in the range of 1 to 100,000 nm, favorably 10 to 50 nm.

[Organic semiconductor layer]:

If the photoelectric conversion action of converting the energy of light into electric energy by irradiation of the light can be exercised, then there can be adopted the same materials and their combinations as of conventional organic solar cells.

Among organic semiconductor layers of common organic solar cells, there is an organic semiconductor layer such that a material layer which functions as an n-type semiconductor and a material layer which functions as a p-type semiconductor are laid on each other. Usually, the n-type layer is disposed on the transparent electrode layer side, and the p-type layer is disposed on the collector electrode layer side. There is also an inverse case. A colorant layer which absorbs the energy of light is also used.

Usable as a material of the organic semiconductor layer is an organic substance having the $\pi$ conjugated system. As to specific examples thereof, examples of substances encompassed in colorants include substances of cyanine types, merocyanine types, phthalocyanine types, naphthalocyanine types, azo types, quinone types, quinoisine types, quinacridone types, squarylium types, triphenylmethane types, xanthene types, porphyrin types, perylene types, and indigo types. Specific examples thereof include H2Pc: 29H,31H-phthalocyanine, MC: merocyanine, Zntpp: 5,10,15,20-tetraphenylporphyrinatozinc, and H2tpp: 5,10,15,20-tetraphenylporphyrin.

Examples of polymer substances include polyacetyne types, polypyrrole types, polythiophene types, polyparaphenylene types, polyparaphenylenevinylene types, polythienylenevinylon types, poly(3,4-ethylenedioxythiophene) types, polyfluorene types, polyaniline types, and polyacene types. Specific examples thereof include polythiophene Pth: poly(3-hexylthiophene-2,5-diyl), PA-PPV: poly(phenylimino-1,4-phenylene-1,2-ethenylene-2,5-dihexyloxy-1,4-phenylene-1,2-ethenylene-1,4-phenylene), and MEH-PPV: poly[2-methoxy-5-(2'-ethylhexyloxy)-1,4-pheneylenevinylene].

Organic superconductive substances typified by TCNQ are also utilizable.

The organic semiconductor layer is constituted by at least two layers of material layers. Each layer can be constituted by a one-material layer or a mixed layer of the above various materials.

Of the at least two material layers constituting the organic semiconductor layer, two layers adjacent thickness-wise to each other are referred to as first material layer and second material layer. Usually, the first material layer is formed in advance, and thereafter the second material layer is formed.

The first material layer may be a material layer having been formed from an insoluble material, or it is also possible that the first material layer is made insoluble after having been formed from a soluble material. In addition, even if being soluble, the first material layer will do if it can form the penetration structure or the thickness-wise through spaces. In the portion, adjacent to the second material layer, of the first material layer, there is constituted the mingled range in which a part of a material of the second material layer is mingled with the first material layer in the form of having entered the through spaces of the first material layer.

The second material layer, which is disposed adjacently to the first material layer, is formed from a soluble material, as which a material that can form a liquid film is used. It is also possible that an insoluble material is used for the second material layer. For example, by such as thin-film formation techniques (e.g. vapor deposition), a particulate insoluble material can be made to enter directly into the spaces which are through from a surface of the first material layer into its inside.

Examples of specific structures of the organic semiconductor layer include a multilayered structure of a PA-PPV layer or MEH-PPV layer with a PV layer: bisbenzimidazo[2, 1-a; 1',2'-b']anthera[2,1,9-def;6,5,10-d'e'f]diisoquinoline-6,11-dione (CAS 55034-81-6). The organic semiconductor structure which is disclosed in the aforementioned non-patent document 1 is also adoptable.

Though depending on materials being used and layer structures, the thickness of the organic semiconductor layer is usually not more than 100 μm, favorably in the range of 100 to 5,000 Å, in total. The thickness of the first material layer and the thickness of the second material layer are set so that their total thickness will be in the above range.

<Mingled range>:

In the mingled range which is provided in the first material layer, there are mingled together a material constituting the first material layer and a material constituting the second material layer.

In the mingled range, it is arranged that the material constituting the first material layer should continue unitedly with the adjacent one-material layer of only the first material, and that the material constituting the second material layer should continue unitedly with the adjacent one-material layer of only the second material. As to a mixed layer in which the first and second materials are uniformly mixed together in a state of particles or lumps that are independent of each other, the first material layer and the first material of the mixed layer do not continue unitedly with each other, and the second material layer and the second material of the mixed layer do not continue unitedly with each other. Therefore, such a mixed layer is not encompassed in the technical conception of the mingled range in the present invention.

If the first material layer is formed in advance, then naturally it follows that the entirety of the first material constituting the first material layer is unitedly continuous. In a part of such a first material layer, there are made the through spaces which are depth-wise continuously through from the surface of the first material layer.

If the liquid film of the second material layer is made to penetrate the beforehand formed first material layer, then the above continuous united structure is easy to form. A part of the material liquid (having been supplied to the surface of the first material layer) for the second material layer enters the inside of the through spaces from the surface of the first material layer and then hardens. The second material, having entered up to the inside of the through spaces and then hardened, comes into a state linked unitedly continuously with the second material layer which is formed on the surface of the first material layer.

Unless the first or second material in the mingled range continues unitedly with the adjacent one-material layer, the object of the present invention cannot sufficiently be achieved.

Hereupon, the united continuation is favorably such that the above material and layer are not apart as physically different bodies but are in one body which is unitedly continuous. However, the objective function can be achieved if the above material and layer are continuous in a state which can be regarded as one structure in the electrical meaning even if they are not in one body which is entirely continuous in the physical meaning. For example, it is possible to conceive a case where the second material layer and the second material part of the mingled range, physically, have a boundary between them and are therefore apart from each other, but, electrically, are in contact with each other in such a degree as can be regarded as one body. A state where particles are electrically conductive between them in close contact with each other can be regarded as electrically one body though physically not one body.

In the mingled range, it is desirable that all the second material part is continuous unitedly with the second material layer, and that all the first material part is continuous unitedly with the first material layer. However, within the range not spoiling the object of the present invention, there may be a part in which a part of the second material existing in the mingled layer is apart from the second material layer without being continuous with it.

The presence ratio between the material of the first material layer and the material of the second material layer in the mingled range may either be constant thickness-wise or vary thickness-wise. For example, the setting can be made so that: near the second material layer, the material of the second material layer will be present in a major ratio; and, as approaching the first material layer side, the presence ratio of the material of the second material layer will decrease. This variation of the presence ratio may be made either continuously or stepwise. In the case of the structure such that the liquid film of the second material layer is made to penetrate the beforehand formed first material layer, the presence ratio is easy to continuously vary.

In the first material layer, the boundary face between the mingled range of the material of the second material layer and the one-material range of the material of the first material layer may be either a flat or uneven face. In the case where the boundary face is the uneven face, dispersion occurs to the thickness of the mingled range according to places face-wise. In the case where the boundary face is uneven in some degree, rather the function of the mingled range can be better exercised.

The ratio of the thickness of the mingled range (which is penetrated or entered by the material of the second material layer) to the overall thickness of the first material layer can be set at not less than 10 %, favorably not more than 90 %, more favorably in the range of 20 to 80 %, still more favorably not more than 60 %. The thickness as hereupon referred to is specified as the average one. It is desirable that the thickness of the mingled range exists at least 5 nm. The variation face-wise of the thickness of the mingled range can be set in the range of $\pm 10$-90 %, favorably not more than $\pm 50$ %, relative to the average thickness.

[Other structures]:

To other layer structures, there can be applied the same techniques as of conventional organic solar cells if the aforementioned transparent electrode layer, the aforementioned organic semiconductor layer (constituted by the at least two material layers including the first and second material layers), and the aforementioned collector electrode layer are laid on each other in this order.

For example, there can be adopted a structure such that the structural portions which participate in the photoelectric conversion action are laid on each other repeatedly in the following order: transparent electrode layer, organic semiconductor layer, collector electrode layer, organic semiconductor layer, and collector electrode layer. Another functional layer can be made to lie in such as between the organic semiconductor layer and the collector electrode layer. A support substrate which supports each layer can be provided. It is also possible to provide a protective layer which protects the organic solar cell. For example, a great electric current can be generated by providing an organic material layer of such as electrically conductive polymer between the organic semiconductor layer and the collector electrode layer. It is also possible to provide an electrically conductive metal thin layer between the transparent electrode layer and the organic semiconductor layer.

[Electrically conductive metal thin layer]:

The electrically conductive metal thin layer performs a function of efficiently retrieving the electric energy photoelectrically converted by the organic semiconductor layer.

The electrically conductive metal thin layer is constituted by a metal material which is excellent in the electric conductivity. Moreover, there is preferred such a material as is excellent in the light transmissibility so as not to hinder the supply of light from the transparent electrode side to the organic semiconductor. There is preferred such a material as does not exercise any bad influence on the photoelectric conversion action of the organic semiconductor layer or on the retrieval of the electric energy to the transparent electrode layer. Specifically, there is preferred such a material as is selected from the group consisting of elements belonging to groups IA, IIA, VIII, IB, IIB, IIIB, and IVB. More specifically, examples thereof include In, Al, Li, Sn, Mg, Ca, Ag, Au, and Pt. It is also possible that at least two material layers are used being laid on each other.

The material of the electrically conductive metal thin layer can be selected appropriately for the material constituting the organic semiconductor layer. There is preferred a combination of materials such that the material of the electrically conductive metal thin layer will make good ohmic contact with the first material layer which is disposed adjacently to the electrically conductive metal thin layer. There is preferred such a material as prevents the back electron transfer from the electrically conductive metal thin layer to the second material layer, for example, by constituting a Schottky barrier in combination with the second material layer. For example, in the case where the second material layer is a p-type semiconductor, such In, Al, Mg, and Ca as have small work functions are favorable as the material of the electrically conductive metal thin layer. In the case where the second material layer is an n-type semiconductor, such as Au and Pt are favorable as the material of the electrically conductive metal thin layer. Because a part of the first material layer is penetrated with the material of the second material layer, there is preferred such a material as makes ohmic contact with the first material layer and prevents the back electron transfer from the electrically conductive metal thin layer to the second material layer in combination with the material of the second material layer. Specifically, such as In can be selected.

As to the electrically conductive metal thin layer, if it is producible and secures such as practical durability, then that which is as thin as possible is better in the light transmissibility. Though depending on the material being used, usually, the thickness is set in the range of 0.1 to 10,000 Å, favorably 5 to 500 Å.

The light transmittance of the electrically conductive metal thin layer is set at not less than 70 %, favorably in the range of 80 to 100 %. Similarly to the transparent electrode layer, the light transmittance is specified as that in the wavelength range of 450 to 900 nm. Particularly favorable is a material of which the light transmittance is high in the range near 500 nm which range is the visible light range in the wavelength range of the sunlight.

To the production of the electrically conductive metal thin layer, there can be applied the means for production of electrically conductive layer in conventional electronic elements and electronic circuits. Thin-film formation means (e.g. CVD, PVD) can be applied thereto.

[Production of organic solar cell]:

Basically applicable are the same production means and production conditions as those in cases of conventional organic solar cells. Various physical or chemical thin-film formation means are adoptable for any of the electrode layers and the organic semiconductor layer which constitute the organic solar cell. To such as metal materials, there can be applied vapor deposition techniques. For soluble materials, film formation means by spin coating of solutions could also be utilized.

Usually, on a substrate made of transparent glass or transparent plastic, there are produced in sequence the electrode layers and the organic semiconductor layer. It is also possible to utilize a transparent electrode substrate obtained by beforehand forming a transparent electrode layer on a transparent substrate.

[Formation of organic semiconductor layer]:

The organic semiconductor layer is formed on one of the pair of electrode layers. On the organic semiconductor layer, there is formed the other electrode layer.

In order to form the organic semiconductor layer, the at least two material layers constituting it are formed in sequence. Basically applied are techniques for formation of each material layer in conventional organic semiconductor layers. Above all, of two layers being formed adjacently to each other, the first material layer being formed in advance and the second material layer being formed thereafter can be formed in the following ways.

<Formation of first material layer>:

As to the first material layer, there are a case where it is formed directly on one of the pair of electrode layers and another case where it is formed on another material layer constituting the organic semiconductor layer.

The means for forming the first material layer is not especially limited. Physical or chemical thin-film formation means (e.g. vapor deposition) are adoptable. If a soluble material is used for the first material layer, then there can also be adopted a process including the steps of coating the soluble material by coating means (e.g. spin coating) and then hardening it. The first material layer is made not to dissolve into a soluble material which is to form a second material layer that will be formed later or into a solvent of this soluble material. In the case where a soluble material is used for the first material layer, its material and treatment method are selected appropriately for a soluble material used for the second material layer and appropriately for the kind of the solvent and treatment conditions of this soluble material.

Favorable are film formation means and production conditions which make fine gaps and spaces in the first material layer wherein the fine gaps and spaces are thickness-wise through from. a surface of the layer into its inside. For example, there are preferred those which form a porous film, or an integrated and united layer of fine particles, or deep unevenness in a surface. Physical thin-film formation means (e.g. vacuum vapor deposition) are easy to form such gaps and spaces, depending on vapor deposition conditions.

The first material layer can be a layer of an n-type semiconductor, a p-type semiconductor, a colorant, or their mixture.

It is desirable that the thickness of the first material layer can sufficiently secure the thickness of the mingled range (which is formed when a part of the soluble material of the second material layer penetrates or enters the first material layer) and further can sufficiently secure the thickness of the second material layer which is constituted by only the soluble material.

<Formation of second material layer>:

The soluble material can be used for the second material layer. As the soluble material, there can be selected a material which can exercise an effective photoelectric conversion action in cooperation with the first material layer. For example, the first material layer which is an n-type semiconductor can be combined with the second material layer which is a p-type semiconductor.

As the soluble material, besides a soluble material which itself is in the form of a liquid, there can also be used a soluble material which forms a liquid by being dissolved or dispersed into a solvent. The soluble material may be such as changes into a soluble state and into an insoluble state dependently on the temperature. As the solvent to dissolve the soluble material into, although depending on the kind of the soluble material, there can be adopted such as chloroform, THF (tetrahydrofuran), benzene, toluene, water, methanol, ethanol, and propanol. Mixed solvents including at least two solvents are also usable.

If a liquid containing the soluble material is coated onto the first material layer, then a liquid film of the soluble material is formed. It is also possible that: a solid soluble material (e.g. powder) is spread or coated onto the first material layer in a state left as it is or in a state dispersed in a dispersion medium, and then the soluble material is dissolved by such as heating, whereby the liquid film of the soluble material is formed.

The lower the viscosity of the soluble material liquid is, the easier it is to carry out the penetration into the first material layer. In the case where the viscosity is too low, it is difficult to form the second material layer in a sufficient thickness.

As a specific means for forming the liquid film of the soluble material, there can be adopted a coating means selected from the group consisting of spin coating, bar coating, and squeegee coating.

The thickness of the liquid film is set so that the thickness of the second material layer can sufficiently be secured in a stage when the second material layer has been formed after the below-mentioned penetration step has been completed. Usually, a liquid film of 10 to 1,000 nm in thickness is formed, though depending on such as kind, concentration, and penetration conditions of the soluble material.

<Penetration step>:

After the liquid film of the soluble material (which is to form the second material layer) has been formed on the first material layer, a part of the soluble material of the second material layer is made to penetrate the first material layer.

If being left as it is, then the liquid film of the soluble material (which is to form the second material layer) does not penetrate the first material layer, but rapidly hardens on the surface of the first material layer to thus form the second material layer.

Thus, there can be taken a means of forcing the liquid film of the second material layer to penetrate the first material layer or promoting this penetration.

For example, by retarding the drying of the liquid film or the hardening of the soluble material, there is promoted the penetration of the soluble material into the first material layer. It is effective to use a low volatile material as the soluble material or its solvent. It is also effective that a treatment atmosphere under which there are carried out the steps of from the formation of the liquid film till the hardening of the soluble material is kept an atmosphere under which the soluble material or its solvent is difficult to volatilize. It is effective that the above treatment atmosphere is kept a saturated vapor atmosphere of the solvent. It is also effective to drop the temperature to thereby make the solvent difficult to volatilize. By adjusting the environmental pressure; it is possible to retard the volatilization of the solvent or to promote the penetration of the soluble material into fine gaps and pores possessed in the first material layer.

The soluble material of the second material layer is made to penetrate halfway through the thickness of the first material layer. The soluble material of the second material layer is not made to penetrate through the entire thickness of the first material layer.

<Hardening step>:

The soluble material of the second material layer is hardened in a state where a part of this soluble material has been made to penetrate the first material layer.

This hardening may start at the same time as the aforementioned formation of the liquid film and the aforementioned penetration into the first material layer. If the hardening of the second material layer has come to completion while the penetration step makes progress, then, at this point of time, both the penetration step and the hardening step finish.

In the case where the hardening step is carried out after the penetration step, it is possible that, in the hardening step, to the contrary to the penetration step, the soluble material of the second material layer is put under environmental conditions where this soluble material hardens as rapidly as possible. Circumferential environmental conditions or atmosphere can be switched between the coating step or penetration step and the hardening step. Specifically, in the hardening step, it is possible to, by raising the temperature by heating, promote the volatilization of the solvent or advance the hardening of the soluble material. It is also effective to eliminate the solvent or volatile components from the atmosphere. It is also effective to expose the soluble material to a reduced-pressure atmosphere. Hardening treatment with such as radiations is also effective.

<Formation of another material layer>:

In the case where the organic semiconductor layer is formed with another material layer added to a pair of first and second material layers, this other material layer can be formed before the first material layer is formed or after the second material layer has been formed. The method for forming the above other material layer is not especially limited. Techniques common to the first or second material layer are also adoptable.

<Means other than penetration>:

As the means of constituting the mingled range in which the material of the second material layer has entered a part of the first material layer, it is also possible to adopt, besides the aforementioned penetration techniques, another method in which the thin-film formation techniques (e.g. vapor deposition) are utilized to make fine particles of the material constituting the second material layer enter directly the thickness-wise through spaces possessed in the first material layer. In this case, it is necessary to use fine particles of sizes possible to enter the through spaces of the first material layer.

[Confirmation of mingled range]:

In order to confirm that there exists the mingled range in which the material of the second material layer is mingled with a part of the first material layer in the form of having entered this part, there can be adopted a method in which a section of the organic semiconductor layer is observed or photographed with an electron microscope. Specifically, a TEM (transmission electron microscope) device is utilizable. It is also possible to quantify the thickness of the mingled range from a photographed image.

In addition, the presence of the mingled range can be confirmed also by measuring an absorption spectrum which varies due to the presence of the mingled range, and it is also possible to quantify the thickness of the mingled range by this measurement.

It is also possible that: the surface structures of the material layers are observed or photographed with an AFM (interatomic force microscope) device and, based thereon, the presence of the mingled range is guessed ahead.

Furthermore, it becomes possible to confirm and quantify the mingled range also by utilizing a device or method which can analyze a fine structure, such as SEM (scanning electron microscope) and EELS (electron energy-loss spectroscopy).

Based on data of the thickness or state of the mingled range confirmed by these means, there can appropriately be set the treatment conditions for the steps of forming the mingled range, such as the aforementioned penetration step.

C. EFFECTS OF THE INVENTION

As to the organic solar cell according to the present invention, the range in which the materials of the first and second material layers are mingled together is present between the first and second material layers constituting the organic semiconductor layer that performs the photoelectric conversion function. Consequently, the photoelectric conversion action in the organic semiconductor layer is extremely efficiently made, so that the photoelectric conversion performance of the organic solar cell can greatly be enhanced.

In the process according to the present invention for production of an organic solar cell, the step of forming the organic semiconductor layer that performs the photoelectric conversion function includes the following steps of: forming a liquid film of the soluble material (which is to form the second material layer) on the first material layer among the at least two material layers constituting the organic semiconductor layer; and then making a part of the soluble material of the second material layer penetrate the first material layer; and then hardening the soluble material. In the organic semiconductor layer of the multilayered structure having been formed by such steps, the range in which the materials of the first and second material layers are mingled together can easily and surely be formed between the first and second material layers. As is aforementioned, the photoelectric conversion action in the organic semiconductor layer is extremely efficiently made, so that the photoelectric conversion performance of the organic solar cell can greatly be enhanced.

These and other objects and the advantages of the present invention will be more fully apparent from the following detailed disclosure.

## BRIEF DESCRIPTION OF THE DRAWINGS

Fig. 1 is a schematic sectional view of an organic solar cell illustrating a mode for carrying out the present invention.
Fig. 2 shows sectional views illustrating the step of forming the liquid film which is to form the second material layer of the organic semiconductor layer.
Fig. 3 is a schematic sectional view illustrating a pre-stage of the formation of the pn-mingled range.
Fig. 4 is a schematic sectional view illustrating the completion stage of the formation of the pn-mingled range.
Fig. 5 is a TEM image view of the comparative sample 1 in which the pn-mingled range is not present.
Fig. 6 is a TEM image view of the working sample 1 in which the pn-mingled range is present.
Fig. 7 shows AFM image views of various semiconductor materials.

[Explanation of the Symbols]

10: Transparent electrode layer
20: Organic semiconductor layer
22: Second material layer
24: First material layer
26: pn-mingled range
30: Collector electrode layer
40: Electrically conductive metal thin layer
50: Wiring

## DETAILED DESCRIPTION OF THE INVENTION

Hereinafter, detailed descriptions are given about the present invention. However, the scope of the present invention is not bound to these descriptions. And other than the following illustrations can also be carried out in the form of appropriate modifications of the following illustrations within the scope not departing from the spirit of the present invention.

[Structure of organic solar cell]:

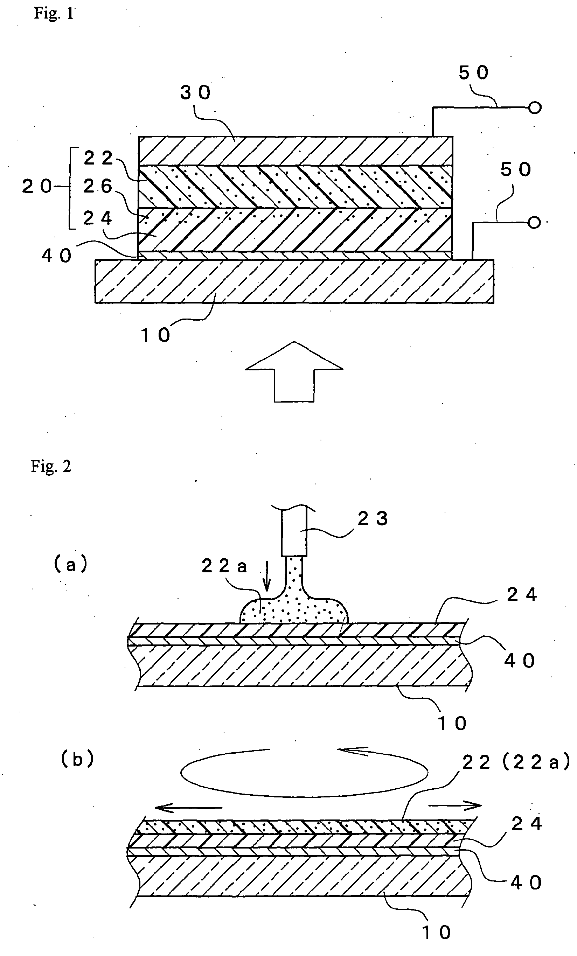

Fig. 1 illustrates a schematic structure of an organic solar cell.
As is shown by a white arrow in this figure, light is presumed to be irradiated from the downside toward the upside.
In order from the downside, there are provided the transparent electrode layer 10, the electrically conductive metal thin layer 40, the organic semiconductor layer 20, and the collector electrode layer 30. Wirings 50, 50 to retrieve the electric power to the outside are connected to the transparent electrode layer 10 and the collector electrode layer 30. The organic semiconductor layer 20 has a multilayered structure of a lower n-type layer 24 and an upper p-type layer 22. Near the boundary adjacent to the p-type layer 22 in the n-type layer 24, there is a pn-mingled range 26 in which the material of the p-type layer 22 is mingled with the n-type layer 24 in the form of having entered the n-type layer 24.

The light is supplied to the organic semiconductor layer 20 after having been transmitted through the transparent electrode layer 10 and the electrically conductive metal thin layer 40. In the organic semiconductor layer 20, the energy of light is converted into electric energy, so that the electromotive force is generated on both sides of the organic semiconductor layer 20.

The electromotive force generated in the organic semiconductor layer 20 is retrieved from the collector electrode layer 30 and the transparent electrode layer 10 via the wirings 50, 50 to the outside.

Hereupon, on the transparent electrode layer 10 side, the electric energy is conveyed from the organic semiconductor layer 20 via the electrically conductive metal thin layer 40 to the transparent electrode layer 10. The electrically conductive metal thin layer 40, which is excellent in the electric conductivity, efficiently performs the conveyance of the electric energy to thus increase the electric energy which can be retrieved to the wirings 50, 50, so that the overall photoelectric conversion efficiency, as an organic solar cell, is greatly enhanced. Because the electrically conductive metal thin layer 40 (having high electric conductivity) exists between the organic semiconductor layer 20 and the transparent electrode layer 10, the electric energy generated in the organic semiconductor layer 20 is efficiently conveyed from the transparent electrode layer 10 to the wiring 50 without causing a great loss, so that the electric energy which can be retrieved to the wirings 50, 50 is greatly increased. Even if the material or structure of the organic semiconductor layer 20 is the same, the substantial photoelectric conversion efficiency of the organic solar cell is greatly enhanced in the case where the electrically conductive metal thin layer 40 exists when compared with the case where it does not exist. The electrically conductive metal thin layer 40, which has high electric conductivity even though thin, little hinders the attainment of the energy of light from the transparent electrode layer 10 to the organic semiconductor layer 20.

In addition, because the aforementioned pn-mingled range 26 exists in the organic semiconductor layer 20, the photoelectric conversion performance in the organic semiconductor layer 20 is greatly enhanced.

[Production of organic solar cell]:

Basically, the production of the organic solar cell is carried out by the same process as of conventional organic solar cells.

In Fig. 1, the transparent electrode layer 10 will do if there is used a transparent electrode substrate (e.g. commercially available ITO substrate) produced by beforehand forming the transparent electrode layer 10 on a surface of a transparent substrate made of such as glass. In Fig. 1, the indication of the transparent substrate is omitted.

Conventional physical or chemical thin-film formation means are adoptable to form the electrically conductive metal thin layer 40 (made of such as In) on the transparent electrode layer 10.

Conventional thin-film formation means are applied also to the formation of the n-type layer 24 which is the first material layer in the organic semiconductor layer 20.

In Fig. 2, the p-type layer 22 which is the second material layer of the organic semiconductor layer 20 is formed by the spin coating method. As is illustrated in Fig. 2 (a), a soluble material liquid 22a is supplied onto the n-type layer 24 from such as a coating nozzle 23. As is illustrated in Fig. 2 (b), the entirety of the lower structure including the n-type layer 24 is horizontally spun at a high speed, so that the soluble material liquid 22a forms an extremely thin liquid film on a surface of the n-type layer 24 by the centrifugal force.

The liquid film 22a dry-hardens due to gradual volatilization of the solvent and, as a result, forms the p-type layer 22.

Hereupon, in order to make the soluble material liquid 22a penetrate the inside of the n-type layer 24, it is arranged that the treatment atmosphere should be filled with a saturated vapor of the solvent of the soluble material liquid 22a. Specifically, the treatment environment under which the soluble material liquid 22a is spin-coated can beforehand be filled with the vapor of the solvent. The treatment environment is put in a hermetic state, so that the vapor of the solvent, which volatilizes from the soluble material liquid 22a, also stagnates without being scattered and lost.

In the state kept under the saturated vapor atmosphere, it takes time to dry-harden the soluble material liquid 22a. In that time, due to the gravitational action or capillary phenomenon, a part of the soluble material liquid 22a penetrates the inside of the n-type layer 24 through the fine unevenness and gaps which are through from the surface of the n-type layer 24 into its inside.

The soluble material liquid 22a is hardened in a state where the soluble material liquid 22a has penetrated the inside of the n-type layer 24 up to a sufficient depth. The soluble material liquid 22a hardens with only a part thereof having penetrated the n-type layer 24 and with much of the rest remaining having formed the film on the n-type layer 24. The p-type layer 22 having a sufficient thickness is formed also on the n-type layer 24. As is illustrated in Fig. 1, consequently, the pn-mingled range 26 is formed in a part of the n-type layer 24.

If the formation of the collector electrode layer 30 and the wirings 50, 50 is carried out thereafter, then the organic solar cell is produced.

[Formation of pn-mingled range]:

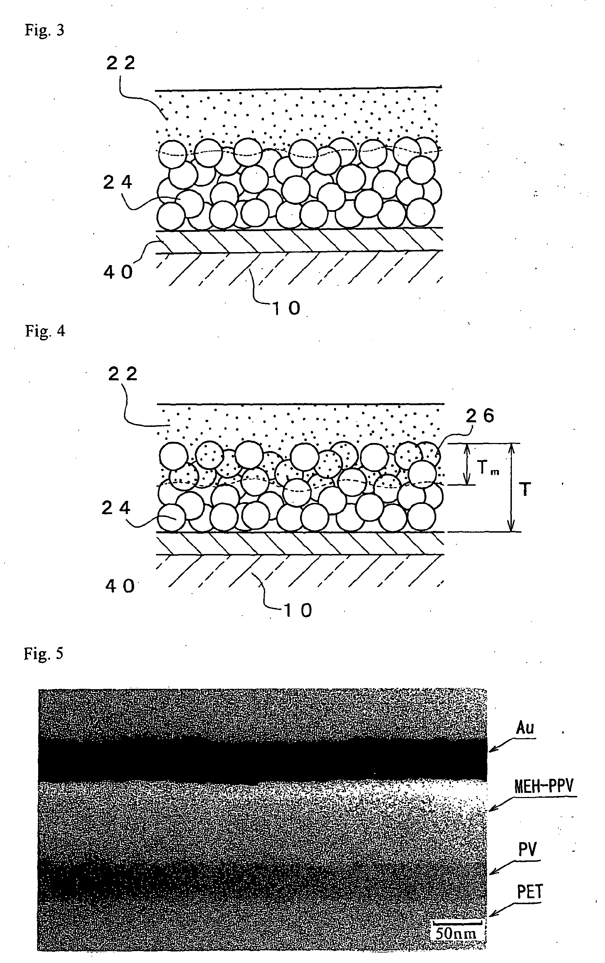

Figs. 3 and 4 schematically illustrate a process in which the pn-mingled range 26 is formed.

Fig. 3 illustrates a stage corresponding to the aforementioned Fig. 2 (a). By being formed by thin-film formation means (e.g. vapor deposition), the earlier formed n-type layer 24 has a structure such that fine particles are integrated together at random. As a result, gaps are opened between particles. In the drawing figure, the n-type layer 24 is constituted by only the same truly spherical particles. However, in fact, there are also particles having shapes of other than the true sphere or particles having different sizes.

If the soluble material liquid 22a is coated onto the n-type layer 24, then the liquid film of the soluble material liquid 22a is formed on surfaces of fine particles constituting the n-type layer 24. Because actions such as surface tension and viscosity are made, it is impossible for the liquid film to immediately enter up to the inside of the n-type layer 24 through gaps between fine particles of the n-type layer 24. A part of the liquid film merely falls in along the unevenness between fine particles exposed to the surface.

Fig. 4 illustrates a stage corresponding to Fig. 2 (b). By such as the aforementioned method in which the treatment atmosphere is kept the saturated vapor atmosphere of the soluble material liquid 22a, it becomes easy for the soluble material liquid 22a to enter the inside of the n-type layer 24 through gaps between fine particles constituting the n-type layer 24. If the thickness Tm of the pn-mingled range 26 (which the soluble material liquid 22a has entered) reaches an appropriate degree relative to the overall thickness T of the n-type layer 24, then the soluble material liquid 22a is not made to enter any more, but is made to harden. Usually, the more deeply the soluble material liquid 22a penetrates the inside of the n-type layer 24, the larger the resistance to this penetration becomes. Therefore, the soluble material liquid 22a comes into a state where: the nearer to the surface of the n-type layer 24 there exists the soluble material liquid 22a, the larger its amount is; and, the more deeply inside the n-type layer 24 there exists the soluble material liquid 22a, the smaller its amount is.

By such a process, there is formed the organic semiconductor layer 20 having the structure such that the n-type layer 24, the pn-mingled range 26, and the p-type layer 22 are arranged in sequence. As a result, the thickness Tm of the pn-mingled range 26 exists in a definite ratio to the overall thickness T of the n-type layer 24.

## DETAILED DESCRIPTION OF THE PREFERRED EMBODIMENTS

Hereinafter, the present invention is more specifically illustrated by the following Examples of some preferred embodiments. However, the present invention is not limited to them in any way.

Organic solar cells of the structure as illustrated in Fig. 1 were specifically produced to evaluate their performances as follows.

[Production of organic solar cells]:

Organic solar cells of layer structures as shown in Tables 1 to 3 were produced as follows.

Used as the transparent electrode layer was the following commercially available ITO substrate having been produced by forming an ITO layer (which was to be the transparent electrode layer) on a surface of a glass substrate.

(1) Produced by Merk Display Technologies, model No. 263-478-60, light transmittance 87 % (measured at a wavelength of 500 nm), thickness 200 nm, resistance 8 $\Omega/\square$.

In some of the Examples and Comparative Examples; In which was to form the electrically conductive metal thin layer was formed on the transparent electrode layer by vapor deposition. The devices used were a vacuum vapor deposition device (VPC-410, produced by ULVAC), a film thickness monitor (CRTM-5000, produced by ULVAC), and a power source for vapor deposition (PSE, 1.5 kVA, produced by ULVAC). The operation procedure and treatment conditions followed conventional methods. The light transmittance of the In layer was 97 % (wavelength 500 nm). As to the light transmittance, a photometer (UV-3100, produced by Shimadzu Corporation) was used to measure the average light transmittance in the wavelength range of 450 to 900 nm.

A PV layer (n-type semiconductor) which was to constitute the first material layer of the organic semiconductor layer was formed on the In layer or transparent electrode layer by vacuum vapor deposition. The vapor deposition devices were the same as those in the case of the In. As the PV material, there was used that which had been produced by a conventional method.

The second material layer of the organic semiconductor layer was formed on the PV layer. For the second material layer, there were used the following materials which were to form the p-type semiconductors.

H2Pc: synthesized by a conventional method
MEH-PPV: trade name ADS100RE, produced by American Dye Source, Inc.
    weight-average molecular weight 634,000
PA-PPV: synthesized by a conventional method, weight-average molecular weight 26,400

The H2Pc was formed by vacuum vapor deposition. As to the MEH-PPV and the PA-PPV, their chloroform solutions were prepared and then spin-coated by use of a spin coater (1H-D7, produced by Mikasa Co., Ltd.). The chloroform solutions had a concentration of about 0.15 wt %. In each Example, the atmosphere for the spin-coating treatment was set so as to be a saturated vapor atmosphere of chloroform at 25 °C. The materials were retained in chloroform vapor for 10 seconds, and then the number of revolutions was gradually raised to make it reach 2,000 rpm in 40 seconds. The materials were retained at 2,000 rpm for 15 seconds, and then, lastly, the atmosphere was displaced with an atmosphere of the air, and then the materials were spun at 2,000 rpm for 20 seconds. In the Comparative Examples, a drop of the chloroform solution of about 0.4 wt % in concentration was dropped and then spin-coated onto a surface of the first material layer which was spinning at 2,000 rpm, with the operation being carried out under an atmosphere of the air from the start of the spin coating till the completion of the hardening.

Lastly, an Au layer which was the collector electrode layer was formed by vapor deposition with the same devices as of the In layer.

In Tables 1 to 3, the numerical values as expressed in the unit "nm" show the thickness of each layer. The film thickness of each layer was measured with a scanning probe microscope AFM (controller NanoScope IIIA and microprobe D3100, produced by US Digital Instruments, Inc., were used).

[Performance evaluation]:

The produced organic solar cells were subjected to the following test.

There was used a device (produced by Kansai Kagaku Kikai) with which light as irradiated from a xenon lamp of 500 W (produced by Ushio, Inc.) was passed through a spectral filter (AM 1.5, produced by Oriel Corporation) to thereby obtain pseudo-sunlight. The intensity of the pseudo-sunlight was 100 mW/cm$^2$.

As to the organic solar cells of 0.04 cm$^2$ in photoelectric conversion area, alligator clips were connected to their electrodes to measure the generated electricity with an electric current and voltage measurement device. This measurement device is provided with an ammeter (487 produced by Keithley Instruments, Inc.), a function generator (HB-105 produced by Hokuto Denko Co., Ltd.), and a potentiostat (HA-5016 produced by Hokuto Denko Co., Ltd.).

Such as short-path photoelectric current density (Isc), open photoelectric voltage (Voc), and fill factor (f. f.) were measured and, from their values, the energy conversion efficiency (η) was calculated in accordance with the following equation.

Fill factor (f. f.) =

[Maximum electromotive force of solar cell]/(Voc × Isc)     (1)

wherein the maximum electromotive force of the solar cell is as follows.

[Maximum electromotive force of solar cell] = [maximum value of

(electric current value × electric voltage value)]

Energy conversion efficiency η (%) =

VOC × Isc ×f. f./100 (mW/cm$^2$) × 100     (2)

The results of the test are shown in Tables 1 to 3.

Table 1

| | | Example 10 | Comparative Example 10 | Example 11 | Comparative Example 11 | Example 12 |
|---|---|---|---|---|---|---|
| <Layer structure and performances (1): PA-PPV> | | | | | | |
| Layer structure: | | | | | | |
| ITO In | Thickness (nm) | (I) 0 | (I) 0 | (I) 5 | (I) 5 | (I) 5 |
| First material layer: | (Vacuum vapor deposition) | | | | | |
| PV | Thickness (nm) | 30.4 | 31.0 | 32.7 | 30.7 | 56.5 |
| Second material layer: | (Spin coating) | | | | | |
| PA-PPV | Thickness (nm) | 37.1 | 39.4 | 43.6 | 41.5 | 35.3 |
| Penetration means | | Saturated vapor | - | Saturated vapor | - | Saturated vapor |
| Au | Thickness (nm) | 24 | 24 | 24 | 24 | 20 |
| Performance evaluation: | | | | | | |
| Isc | mA/cm$^2$ | 3.15 | 1.93 | 5.25 | 3.42 | 4.51 |
| Voc | V | 0.39 | 0.53 | 0.63 | 0.60 | 0.61 |
| f. f. | | 0.34 | 0.32 | 0.42 | 0.43 | 0.43 |
| η | % | 0.42 | 0.33 | 1.40 | 0.88 | 1.18 |

Table 2

| | | Example 20 | Comparative Example 20 | Example 21 | Comparative Example 21 |
|---|---|---|---|---|---|
| <Layer structure and performances (2): MEH-PPV> | | | | | |
| Layer structure: | | | | | |
| ITO In | Thickness (nm) | (I) 0 | (I) 0 | (I) 5 | (I) 5 |
| First material layer: | (Vacuum vapor deposition) | | | | |
| PV | Thickness (nm) | 40,1 | 25.1 | 30.8 | 30.0 |
| Second material layer: | (Spin coating) | | | | |
| MEH-PPV Penetration means | Thickness (nm) | 33.0 Saturated vapor | 33.1 — | 39.0 Saturated vapor | 43.1 — |
| Au | Thickness (nm) | 24 | 24 | 24 | 24 |

Table 2   (continued)

| <Layer structure and performances (2): MEH-PPV> | | | | | |
|---|---|---|---|---|---|
| | | Example 20 | Comparative Example 20 | Example 21 | Comparative Example 21 |
| Performance evaluation | | | | | |
| Isc | mA/cm$^2$ | 3.41 | 2.62 | 3.78 | 2.90 |
| Voc | V | 0.58 | 0.61 | 0.65 | 0.67 |
| f. f. | | 0.35 | 0.35 | 0.46 | 0.48 |
| η | % | 0.69 | 0.56 | 1.13 | 0.94 |

Table 3

| <Layer structure and performances (3): H2Pc> | | | |
|---|---|---|---|
| | | Comparative Example 30 | Comparative Example 31 |
| Layer structure: | | | |
| ITO In | Thickness (nm) | (I) 0 | (I) 5 |
| First material layer: | | (Vacuum vapor deposition) | |
| PV | Thickness (nm) | 30.0 | 25.5 |
| Second material layer: | | (Vacuum vapor deposition) | |
| H2Pc | Thickness (nm) | 48.7 | 51.5 |
| Au | Thickness (nm) | 24 | 24 |
| Performance evaluation: | | | |
| Isc | mA/cm$^2$ | 2.17 | 2.54 |
| Voc | V | 0.41 | 0.53 |
| f. f. | | 0.49 | 0.49 |
| η | % | 0.43 | 0.66 |

<Evaluation>:

(1) When comparisons are made between the Examples and Comparative Examples having the same assignment numbers (e.g.: between Example 10 and Comparative Example 10; between Example 20 and Comparative Example 20), they are substantially the same as each other as to the materials being used and the layer structures.

However, they differ from each other in point of whether, in the step of forming the second material layer, the penetration into the first material layer is promoted by the saturated vapor atmosphere (Examples), or no especial means of promoting the penetration is taken (Comparative Examples).

As to the performances of the produced organic solar cells, in any case, the short-path photoelectric current density (Isc) and the energy conversion efficiency (η) are greatly enhanced in the Examples (in which the penetration promotion by the saturated vapor was carried out) when compared with those in the Comparative Examples. As to the open photoelectric voltage (Voc) and the fill factor (f. f.), the Examples are almost equal to the Comparative Examples.

Accordingly, it follows that, even if the layer structure itself of the organic solar cell is the same, the great enhancement of performances can be achieved by carrying out the aforementioned penetration promotion in the production process.

(2) When comparisons are made between Examples 10 and 11 and between Examples 20 and 21, it is understood that, if the In layer exists between the first material layer and the transparent electrode layer (Examples 11 and 21), then the performances are more enhanced.

(3) The Example which can achieve the highest photoelectric conversion performance is Example 11 in which: the PA-PPV was used for the second material layer, and the In layer was also formed.

The reason for this can be inferred as follows: because the PA-PPV which was used for the second material layer is lower in molecular weight and in viscosity of chloroform solution than the MEH-PPV, the penetration into the first material layer was well made. In addition, the further reason can be inferred as follows: because the In layer is present, the isolation between the PA-PPV (having penetrated the first material layer up to its depth) and the transparent electrode layer is surely made by the In layer.

(4) Also when compared with the cases where both the first and second material layers were formed by vacuum vapor deposition (Comparative Examples 30 and 31), much more excellent performances could be exercised in the Examples.

<Consideration>:

The reason why the enhancement of the performances of the organic solar cell can be achieved in the Examples can be considered as follows.

(1) In the organic semiconductor layer, if a part of the soluble material to constitute the second material layer penetrates the first material layer to thus form the pn-mingled layer, then it follows that, in a part, near the second material layer, of the first material layer, the area of the interface where the two kinds of semiconductor materials are adjacent to each other increases substantially greatly.

Consequently, it can be considered that: the photoelectric conversion action between the two kinds of semiconductor materials is efficiently made, so that the short-path photoelectric current density (Isc) and the energy conversion efficiency ($\eta$) have greatly been enhanced.

(2) Incidentally, if the entirety of the organic semiconductor layer is constituted by a mixed layer of a mixture of the materials of the first and second material layers, then the aforementioned area of the interface where the two kinds of semiconductors are adjacent to each other is expected to more increase.

However, in the case of the mixed layer, for example, the semiconductor material of the first material layer contacts with the collector electrode layer or is disposed at a short distance therefrom, or the semiconductor material of the second material layer contacts with the transparent electrode layer or is disposed at a short distance therefrom. For example, if the n-type layer (which is the first material layer) and the collector electrode layer are in contact with each other or close to each other, then a sufficient electric potential barrier is hindered from being constituted between both. Also between the p-type layer (which is the second material layer) and the transparent electrode layer, the similar problem occurs.

Also from the principle of the photoelectric conversion action in the organic solar cell, it can easily be understood that no high photoelectric conversion efficiency can be achieved unless the sufficient electric potential barrier is constituted between the semiconductor material and the opposite electrode.

(3) It can be considered effective that: as in the aforementioned Examples, the first and second material layers themselves exist in sufficient thickness and, in the interface range between both layers, a part of the material of the second material layer penetrates the first material layer to thus increase the substantial interface area between both layers.

[Confirmation of pn-mingled range]:

The presence of the pn-mingled range and its structure in the organic solar cells obtained from the aforementioned Examples were confirmed as follows. However, there were prepared samples such that the structure having no direct relation with the confirmation of the pn-mingled range was omitted.

<Preparation of samples>:

On a PET-film-made substrate, there was formed a PV layer (n-type semiconductor) of 40 nm in thickness by vacuum vapor deposition. Onto it, there was spin-coated an MEH-PPV layer (p-type semiconductor) of 80 nm in thickness. Further thereon, there was formed an Au layer of 40 nm in thickness by vacuum vapor deposition. This is a layer structure common to the aforementioned Examples 20, 21 and Comparative Examples 20, 21.

However, as to the step of spin-coating the MEH-PPV layer, there were prepared: a sample (comparative sample 1) by, in the same way as of such as the aforementioned Comparative Example 20, merely dropping a drop of an MEH-PPV-containing chloroform solution onto the substrate (on which the PV layer had been formed by the vapor deposition) while spinning this substrate at 2,000 rpm in the air; and a sample (working sample 1) by, under the same treatment conditions as of such as the aforementioned Example 20, putting the substrate (on which the PV layer had been formed by the vapor deposition) under a saturated vapor atmosphere of chloroform and making the MEH-PPV-containing chloroform solution penetrate the above substrate with a sufficient penetration time spent.

<TEM image>]

From the resultant samples, samples for TEM measurement were prepared by a conventional method. Specifically, thin-film pieces having a film thickness of 100 nm were prepared by a super thin piece-cutting method. A TEM image of each sample was photographed by a conventional method. FE-TEM (HF-2000, produced by Hitachi Seisakusho Co., Ltd., acceleration voltage 200 kV) was used as the analysis device.

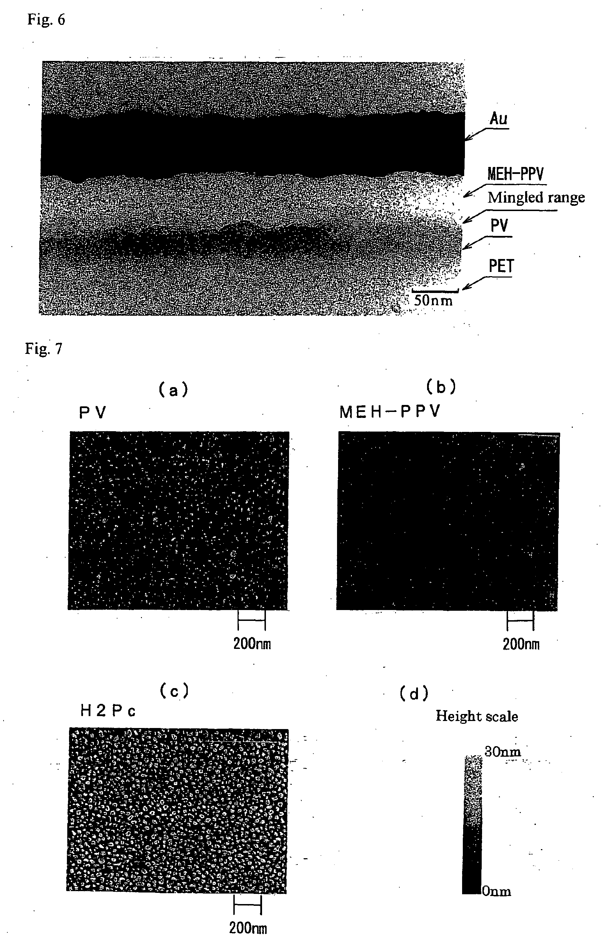

Fig. 5 is a TEM image of the comparative sample 1, and Fig. 6 is a TEM image of the working sample 1. In both images, there are indicated the PET layer (light gray), the PV layer (dark gray), the MEH-PPV layer (light gray), and the Au layer (black) in that order from the downside.

In the case of the comparative sample 1, the boundary line between the PV layer and the MEH-PPV layer is almost flat and distinct.

In the case of the working sample 1, unevenness is seen on the boundary line between the PV layer and the MEH-PPV layer, and this boundary line is considerably blurred and indistinct.

Therefrom, it follows that the working sample 1 was in the same state (refer to Fig. 3) as of the comparative sample 1 in the stage when the MEH-PPV-containing chloroform solution had been dropped, but that the addition of the penetration step brought the working sample 1 into a state (refer to Fig. 4) where there existed the range in which the material of the MEH-PPV layer was mingled with the PV layer in the form of having penetrated up to the inside of the PV layer. It can be inferred that the pn-mingled range, in which the PV layer is penetrated with the material of the MEH-PPV layer, exists in a degree of about 30 nm in thickness relative to the thickness 40 nm of the original PV layer. It can be inferred that a range in which the PV layer exists alone as it is remains in a degree of about 10 nm in thickness, also. Within the scope of the image, a dispersion of the thickness of the mingled range is caused in a degree of ±40 % relative to the average thickness. Incidentally, the PV in the PV layer constitutes crystals of about 14 A in crystal lattice. It is found that the aforementioned crystal state is maintained also in the range where the boundary between the PV layer and the MEH-PPV layer is blurred in the image of the working sample 1.

<Confirmation from absorption spectrum>:

The aforementioned TEM image can specifically indicate the PV layer, the MEH-PPV layer, and the pn-mingled range in which the PV layer is penetrated with the MEH-PPV However, if each layer and the range are narrow, there is a case where the boundary between layers or the thickness of each layer is difficult to clearly see in the TEM image.

In that case, the pn-mingled range included in the PV layer can be confirmed by measuring the absorption spectra of the samples. Specifically, because the thicknesses of the PV layers and of the MEH-PPV layer vary according to whether the pn-mingled range exists or not, a difference between the absorption spectra is made. It supports the existence of the pn-mingled range that a difference between the absorption spectra is made in spite of the formation from the very same material into the same thickness. It is also possible to quantify the thickness variation amount, namely, the thickness of the pn-mingled range, from the difference between the absorption spectra.

<AFM image>:

From images taken with the scanning probe microscope AFM (which was used to measure the film thickness of each layer), it can be confirmed that, in the aforementioned Examples and Comparative Examples, the PV layer constitutes the fine-particles-integrated structure as illustrated in Figs. 3 and 4.

Fig. 7 is an AFM image taken in a state where the appropriate material layers were formed on the glass substrate. In the AFM image, the clearer portion (white) shows that the thickness is larger, and the darker portion (black) shows that the thickness is smaller. As is illustrated in Fig. 7 (d), these correspond to the thickness range of from 0 nm (black) to 30 nm (white).

Fig. 7 (a) illustrates a case where the PV layer is formed alone, and is a state where nearly circular clear spots are dispersed at random. Spots different in clearness are also included. There also exist portions which are spot-free and very dark. This shows that the PV particles are integrated together at random, and that gaps are opened between particles. From this AFM image, it can be inferred that in the PV layer there exists unevenness in a degree of 1 to 20 nm continuously from the surface to the inside. It can be inferred that the unevenness of the PV layer surface (i.e. the pn-mingled range) in the aforementioned TEM image of Fig. 6 corresponds to the PV-particles-integrated structure having shown itself in the AFM image.

In the case of the MEH-PPV layer as illustrated in Fig. 7 (b), there is no clear spot like in the case of the PV layer. The difference in clearness partly exists, but is in a blurred state blended with the surroundings.. This shows that the MEH-PPV layer is in the form of a continuous film having been formed by hardening of a smooth liquid film.

Also from this fact, it can be expected that, when the MEH-PPV layer is formed on the PV layer, a part of the liquid film to constitute the MEH-PPV layer enters gaps between particles in the PV layer, so that the pn-mingled range is formed.

As is illustrated in Fig. 7 (c), in the case of the H2Pc layer having been formed by vacuum vapor deposition, distinct spots are arranged at intervals unlike in the case of the MEH-PPV layer. This shows a state where H2Pc particles are accumulated. When the sizes of the distinct spots, namely, the particle diameters of the H2Pc particles, are compared with the gaps between the PV particles in the PV layer in Fig. 7 (a), it can be inferred that, even if the H2Pc layer is formed on the PV layer, it is difficult for the H2Pc particles to deeply enter the gaps between the PV particles. It is found that the pn-mingled range in the present invention is difficult to form by the combination of the PV layer and the H2Pc layer formed by vacuum vapor deposition.

[Lying in between of organic material layer]:

An organic material layer is made to lie between the organic semiconductor layer and the collector electrode layer in the structures of the organic solar cells in the aforementioned Examples, whereby it is intended to enhance the performances of the organic solar cells.

<Production of organic solar cells>:

Basically, the materials and production processes common to the aforementioned Examples 10 and 11 were adopted. However, after the formation of the PA-PPV layer, a PEDOT:PSS [polystyrenesulfonate/poly(2,3-dihydrothieno-[3,4-b]-1,4-dioxine)] layer was formed as the organic material layer, and then, thereon, the Au layer was formed.

The resultant organic solar cells have almost the same layer structures as of Examples 10 and 11 except the PEDOT:PSS layer.

In addition, the materials and production process common to the aforementioned Example 21 were adopted to also produce an organic solar cell such that the same PEDOT:PSS layer as the aforementioned is formed between the MEH-PPV layer and the Au layer.

In all the above cases, the formation of the PEDOT:PSS layer was carried out in the following way. A 1.3 wt % aqueous dispersion liquid (produced by Aldrich, Inc.) of the PEDOT:PSS was dropped onto the PA-PPV layer or MEH-PPV layer on the substrate in the air, and then spinning was carried out at 8,000 rpm for 2 minutes, and then drying was carried out under a vacuum of $4 \times 10^{-3}$ Pa ($3 \times 10^{-5}$ torr) at 100 °C for 5 minutes, and then the temperature was dropped down to not higher than 50 °C with 45 minutes spent.

It is by the same vacuum vapor deposition as in such as Example 10 that the Au layer is formed on the PEDOT:PSS layer.

<Performance evaluation>:

The same various performance evaluation tests as the aforementioned were carried out. Their results are shown in Tables 4 and 5.

Table 4

| <Addition of organic material layer (1): PA-PPV> | | | | | | |
|---|---|---|---|---|---|---|
| | | Example 40 | Example 41 | Example 42 | Example 43 | Example 44 |
| Layer structure | | | | | | |
| ITO | | (I) | (I) | (I) | (I) | (I) |
| In | Thickness (nm) | 5 | 5 | 5 | 5 | 5 |

Table 4   (continued)

| <Addition of organic material layer (1): PA-PPV> | | | | | | |
|---|---|---|---|---|---|---|
| | | Example 40 | Example 41 | Example 42 | Example 43 | Example 44 |
| First material layer | (Vacuum vapor deposition) | | | | | |
| PV | Thickness (mn) | 35.4 | 39.4 | 7.9 | 109.6 | 32.3 |
| Second material layer: | (Spin coating) | | | | | |
| PA-PPV Penetration means | Thickness (nm) | 43.0 | 47.4 | 41.3 (Saturated vapor) | 52.5 | 23.4 |
| PEDOT:PSS | Thickness (nm) | 50 | 50 | 50 | 50 | 50 |
| Au | Thickness (mn) | 20 | 20 | 20 | 20 | 20 |
| Performance evaluation: | | | | | | |
| Isc | mA/cm$^2$ | 5.65 | 6.13 | 4.56 | 5.23 | 4.04 |
| Voc | V | 0.59 | 0.62 | 0.60 | 0.53 | 0.63 |
| f. f. | | 0.48 | 0.50 | 0.48 | 0.48 | 0.50 |
| η | % | 1.62 | 1.90 | 1.31 | 1.32 | 1.26 |

Table 5

| <Addition of organic material layer (2): MEH-PPV> | | |
|---|---|---|
| | | Example 50 |
| Layer structure: | | |
| ITO In | Thickness (nm) | (I) 5 |
| First material layer: | | Vacuum vapor deposition |
| PV | Thickness (nm) | 33.0 |
| Second material layer: | | Spin coating |
| MEH-PPV Penetration means | Thickness (nm) | 31.4 Saturated vapor |
| PEDOT:PSS | Thickness (nm) | 50 |
| Au | Thickness (nm) | 20 |
| Performance evaluation | | |
| Isc | mA/cm$^2$ | 5.03 |
| Voc | V | 0.61 |
| f.f. | | 0.51 |
| η | % | 1.55 |

<Evaluation>:

(1) The effectiveness of the organic material layer is found from comparison between Tables 4 and 1 which are common to each other in basic layer structure or from comparison between Tables 5 and 2 which are common to each other in basic layer structure.

(2) For example, Example 40 of Table 4 is almost common to Example 11 of Table 1 in such as materials being used and thickness of each layer. In Example 40 in which the organic material layer (PEDOT:PSS) is provided, the short-path photoelectric current density (Isc) is greatly increased when compared with that in Example 11. The fill factor (f. f.) and the energy conversion efficiency (η) are also enhanced. However, the open photoelectric voltage (Voc) is decreased a little. Accordingly, the presence of the organic material layer is effective in uses for which a large electric current Isc is needed even if the electric voltage Voc is not so high.

(3) Also as to the other Examples of Table 4, if it is taken into consideration that they differ from each Example of Table 1 in layer thickness, then, on the whole, there is seen a tendency such that a large electric current is obtained, but that the electric voltage is lowered a little.

(4) In Example 42 of Table 4, the PV layer is considerably thin, but a large electric current is obtained nevertheless. Like in Example 44 of Table 4, even if the overall thickness of the organic semiconductor layer is thin, a large electric current is obtained.

(5) Also in comparison between Example 50 of Table 5 and Example 21 of Table 2, there is seen a tendency such that a large electric current is obtained by the organic material layer.

<Consideration>:

(1) Although not theoretically clear, the reason why a large electric current is obtained by the lying of the organic material layer between the organic semiconductor layer and the collector electrode layer like in each Example can be considered as follows.

(2) The PEDOT:PSS, which constitutes the organic material layer, is an electrically conductive polymer. It is common to the PA-PPV or MEH-PPV of the organic semiconductor layer in point of being an organic material and is good also in electrical contact performance. It has good performance of electrical contact also with the Au of the collector electrode layer. In addition, the exciton loss in the Au is prevented.

It can be inferred that: as a result, the performance of electrical contact between the organic semiconductor layer and the collector electrode layer has been improved, and the electric resistance has therefore been reduced, and the loss of the electric current has therefore been decreased, so that the large electric current has been obtained. Furthermore, it can be inferred that: because it has become possible that the light absorbed by the organic material of the second material layer is also utilized for the conversion into electric energy, the still larger electric current has been obtained.

(3) The quality deterioration and performance lowering of the organic semiconductor layer, which are involved by the step of forming the organic material layer, could be prevented by carrying out the step of forming the organic material layer on the organic semiconductor layer not under the atmospheric pressure but under a reduced pressure or by carrying out the treatment (e.g. heat-drying) at a temperature lower than the decomposition temperature of the constitutional material of the organic semiconductor layer.

As to this, when exposed to high temperature under the atmospheric pressure, the constitutional material of the organic semiconductor layer undergoes such as oxidation action to thus decompose, so that the property is changeable, for example, such as discoloring occurs. If the organic semiconductor layer is put under reduced-pressure environment or under the temperature not higher than the decomposition temperature, then such a change in property is prevented from occurring.

(4) As to the material of the organic material layer, it can be considered possible to achieve the same effects even if polymers having the conjugated system other than the PEDOT:PSS, and besides, such as other electrically conductive polymers which can improve the performance of electrical contact between the organic semiconductor layer and the collector electrode layer, are used.

**INDUSTRIAL APPLICATION**

The organic solar cell according to the present invention can efficiently convert the sunlight into the electric power and is useful as a power source or assistant power source in mobile objects, buildings, and other various instruments and devices.

Various details of the invention may be changed without departing from its spirit not its scope. Furthermore, the foregoing description of the preferred embodiments according to the present invention is provided for the purpose of illustration only, and not for the purpose of limiting the invention as defined by the appended claims and their equivalents.

**Claims**

1. An organic solar cell, which is an organic solar cell comprising a pair of electrode layers and therebetween an organic semiconductor layer including at least two material layers,
   wherein the organic semiconductor layer includes:

   a first material layer having thickness-wise through spaces;
   a second material layer being disposed adjacently to the first material layer; and
   a mingled range which is disposed in a part, adjacent to the second material layer, of the first material layer and in which a part of a material of the second material layer is mingled with the first material layer in the form of having entered the through spaces of the first material layer.

2. An organic solar cell according to claim 1, wherein the ratio of the thickness of the mingled range to the overall thickness of the first material layer is not less than 10 %.

3. A process for production of an organic solar cell, which is a process for production of the organic solar cell including a pair of electrode layers and therebetween an organic semiconductor layer including at least two material layers,
   with the process comprising:

   a step (A) of preparing one of the pair of electrode layers;
   a step (B) of forming the at least two material layers (constituting the organic semiconductor layer) on the prepared one of the pair of electrode layers in sequence; and
   a step (C) of forming the other electrode layer of the pair of electrode layers on the organic semiconductor layer;

   wherein the step (B) includes:

   a step (b-1) of film-forming a first material layer being one of the at least two material layers;
   a step (b-2) of forming a liquid film of a soluble material on the first material layer, wherein the soluble material is to form a second material layer that is a material layer different from the first material layer;
   a step (b-3) of making a part of the soluble material of the liquid film penetrate the first material layer side; and
   a step (b-4) of hardening the soluble material to thereby form the second material layer.

4. A process according to claim 3 for production of an organic solar cell, wherein:

   in the step (A), a transparent electrode layer is prepared as the one of the pair of electrode layers;
   between the steps (A) and (B); there is further included a step (M) of forming an electrically conductive metal thin layer having a light transmittance of not less than 70 %;
   in the step (b-1), the first material layer is formed by vapor deposition;
   in the step (b-2), the liquid film is formed by coating a solution of the soluble material (which is to form the second material layer) by a coating means selected from the group consisting of spin coating, bar coating, and squeegee coating;
   in the step (b-3), the liquid film is kept under a saturated vapor atmosphere; and
   in the step (C), a collector electrode layer is formed as the other electrode layer.

5. An organic solar cell, which is an organic solar cell obtained by the production process as recited in claim 3 or 4, with the organic solar cell comprising:

   the pair of electrode layers;
   the organic semiconductor layer being disposed between the pair of electrode layers and including the at least two material layers;
   the first material layer being one of the material layers constituting the organic semiconductor layer; and

the second material layer that is one of the material layers constituting the organic semiconductor layer and is disposed adjacently to the first material layer and is formed from the soluble material;

wherein the first material layer side is penetrated with a part of the soluble material constituting the second material layer.

Fig. 1

Fig. 2

(a)

(b)

Fig. 3

Fig. 4

Fig. 5

Fig. 6

Au

MEH-PPV
Mingled range

PV

PET

50nm

Fig. 7

(a)

P V

200nm

(b)

MEH−PPV

200nm

(c)

H 2 P c

200nm

(d)

Height scale

30nm

0nm